# DEMANDE DE BREVET EUROPEEN

(11) **EP 1 603 138 A1**
(43) Date de publication de la demande: **07.12.2005**
(21) Numéro de dépôt: 05007725.4
(22) Date de dépôt: 08.04.2005
(51) Int. Cl.: G11C 16/22, G11C 16/26, G11C 7/24

(54) **Mémoire non volatile comprenant des moyens de brouillage de la lecture de cellules mémoire**

(30) Priorité: 15.04.2004 FR 0403914
(71) Demandeur: STMicroelectronics SA, 92210 Montrouge (FR)
(72) Inventeur: Lisart, Mathieu, 13100 Aix en Provence (FR)
(74) Mandataire: Marchand, André

(57) **Abrégé**

L'invention concerne une mémoire non volatile (MEM1) comprenant un plan mémoire (MA1, MA2) comportant des cellules mémoire fonctionnelles (CE_{i,j,k}) et des cellules mémoire non fonctionnelles (CE_{N,j,k}) reliées à au moins une ligne de mot non fonctionnelle (WL_{N}). Un décodeur d'adresse de ligne de mot (WLDEC1) comprend une section de décodage spéciale (S1) reliée à la ligne de mot non fonctionnelle, pour sélectionner la ligne de mot non fonctionnelle quand une ligne de mot fonctionnelle est sélectionnée en lecture, de telle sorte que des cellules mémoire non fonctionnelles sont sélectionnées simultanément aux cellules mémoire fonctionnelles, et brouillent la lecture des cellules mémoire fonctionnelles. Application notamment aux circuits intégrés pour cartes à puce.

## Description

La présente invention concerne les mémoires non volatiles, notamment les mémoires effaçables et programmables électriquement du type EEPROM et Flash.

L'utilisation des mémoires non volatiles effaçables et programmables électriquement s'est généralisée ces dernières années, et l'on trouve de telles mémoires dans un grand nombre de circuits intégrés. Dans certaines applications, il est parfois souhaité que le contenu d'une mémoire non volatile puisse être effacé dans un délai très bref lors de la survenance d'un évènement inattendu ou interdit. Ainsi, les circuits intégrés pour cartes à puce sont équipés de mémoires du type précité dans lesquelles sont stockées des informations confidentielles tels des codes de cryptographie, des mots de passe, des données d'identification, etc.. Lorsque survient une tentative de fraude, il est prévu de procéder rapidement à la destruction des informations confidentielles.

La destruction du contenu d'une mémoire non volatile consiste généralement en un effacement pur et simple de tout le plan mémoire. Cette solution présente toutefois le désavantage d'être longue à mettre en oeuvre, notamment dans les mémoires EEPROM effaçables par mot, car l'effacement du plan mémoire s'effectue mot par mot.

Ainsi, la présente invention vise un procédé permettant de rendre indisponible le contenu d'une mémoire non volatile, sans effacement des cellules mémoire.

A cet effet, la présente invention propose de prévoir un moyen de brouillage de la lecture des données présentes dans la mémoire plutôt qu'une destruction proprement dite des données. Un tel brouillage peut être réversible ou irréversible.

Il est connu que le plan mémoire d'une mémoire non volatile comporte des cellules mémoire connectées à des lignes de mot et à des lignes de bit. Les lignes de bit sont reliées à des amplificateurs de lecture, et la valeur des données lues par les amplificateurs de lecture dans les cellules mémoire est fonction de l'état passant ou bloqué des cellules mémoire au moment où une tension de lecture leur est appliquée. L'état passant ou bloqué d'une cellule mémoire est lui-même fonction de l'état, programmé ou effacé, dans lequel la cellule mémoire a été placée.

Afin de brouiller la lecture de données dans le plan mémoire, l'idée de l'invention est de prévoir des cellules mémoire non fonctionnelles connectées aux lignes de bit du plan mémoire et sélectionnables grâce à une ligne de mot non fonctionnelle, et de sélectionner les cellules mémoire non fonctionnelles au moment où des cellules fonctionnelles sont sélectionnées en lecture. Ainsi, les cellules mémoire non fonctionnelles sont simultanément sélectionnées et interfèrent sur la lecture des cellules mémoire fonctionnelles. Les valeurs logiques fournies par les amplificateurs de lecture se trouvent alors, en tout ou en partie, faussées.

Plus particulièrement, la présente invention prévoit un procédé pour brouiller la lecture de données dans des cellules mémoire fonctionnelles d'un plan mémoire non volatile, dans lequel les cellules mémoire fonctionnelles sont reliées à des lignes de mot fonctionnelles et à des lignes de bit, les lignes de bit étant reliées à des amplificateurs de lecture, et dans lequel la valeur d'une donnée lue par un amplificateur de lecture dans une cellule mémoire est fonction de l'état passant ou bloqué de la cellule mémoire, qui est lui-même fonction de l'état programmé ou effacé de la cellule mémoire, le procédé comprenant les étapes consistant à: prévoir des cellules mémoire non fonctionnelles reliées aux lignes de bit du plan mémoire et à au moins une ligne de mot non fonctionnelle permettant de sélectionner les cellules mémoire non fonctionnelles, et quand des cellules mémoire fonctionnelles sont sélectionnées en lecture, sélectionner simultanément des cellules mémoire non fonctionnelles, de telle sorte que les cellules mémoire non fonctionnelles se trouvant dans l'état passant interfèrent sur la lecture des cellules mémoire fonctionnelles se trouvant dans l'état bloqué, et provoquent la fourniture de valeurs logiques faussées en sortie des amplificateurs de lecture.

Selon un mode de réalisation, le procédé comprend la prévision d'un décodeur d'adresse de ligne de mot comprenant une section de décodage spéciale reliée à la ligne de mot non fonctionnelle, pour appliquer un signal de sélection à la ligne de mot non fonctionnelle quand une ligne de mot fonctionnelle est sélectionnée en lecture par le décodeur d'adresse de ligne de mot.

Selon un mode de réalisation, le procédé comprend la prévision d'une section de décodage spéciale qui est activée par un signal d'autorisation de brouillage, les cellules mémoire non fonctionnelles n'étant pas sélectionnées tant que la section de décodage spéciale n'est pas activée.

Selon un mode de réalisation, le procédé comprend la prévision d'un registre pour la mémorisation d'un bit d'autorisation de brouillage dont la valeur détermine la valeur du signal d'autorisation de brouillage.

Selon un mode de réalisation, le procédé comprend une étape consistant à porter toutes les cellules mémoire non fonctionnelles dans un état déterminé, programmé ou effacé, de manière que toutes les cellules mémoire non fonctionnelles soient dans l'état passant lorsqu'elles sont sélectionnées, afin de fausser la lecture de toutes les cellules mémoire fonctionnelles.

Selon un mode de réalisation, le procédé comprend une étape consistant à porter une partie seulement des cellules mémoire non fonctionnelles dans un état déterminé, programmé ou effacé, de manière que les cellules mémoire non fonctionnelles soient dans l'état passant lorsqu'elles sont sélectionnées, afin de fausser la lecture d'une partie seulement des cellules mémoire fonctionnelles.

Selon un mode de réalisation, la ligne de mot non fonctionnelle est mélangée aux lignes de mot fonctionnelles, et se trouve à un emplacement pouvant correspondre à celui d'une ligne de mot fonctionnelle.

Selon un mode de réalisation, le procédé comprend la prévision de cellules mémoire non fonctionnelles ayant la même structure que les cellules mémoire fonctionnelles et ne pouvant être distinguées visuellement de celles-ci.

Selon un mode de réalisation, le procédé comprend la prévision de cellules mémoire non fonctionnelles comportant des transistors factices présentant un court-circuit drain-source.

La présente invention concerne également une mémoire non volatile comprenant un plan mémoire comportant des cellules mémoire fonctionnelles reliées à des lignes de mot fonctionnelles et à des lignes de bit, les lignes de bit étant reliées à des amplificateurs de lecture, les lignes de mot étant reliées à un décodeur d'adresse de ligne de mot, la valeur d'une donnée lue par un amplificateur de lecture dans une cellule mémoire étant fonction de l'état passant ou bloqué de la cellule mémoire, qui est lui-même fonction de l'état programmé ou effacé de la cellule mémoire, mémoire dans laquelle le plan mémoire comprend des cellules mémoire non fonctionnelles reliées aux lignes de bit du plan mémoire et à au moins une ligne de mot non fonctionnelle, et le décodeur d'adresse de ligne de mot comprend une section de décodage spéciale reliée à la ligne de mot non fonctionnelle, pour sélectionner la ligne de mot non fonctionnelle quand une ligne de mot fonctionnelle est sélectionnée en lecture, de telle sorte que des cellules mémoire non fonctionnelles sont sélectionnées simultanément aux cellules mémoire fonctionnelles et brouillent la lecture des cellules mémoire fonctionnelles.

Selon un mode de réalisation, la section de décodage spéciale du décodeur d'adresse de ligne de mot est activée par un signal d'autorisation de brouillage, les cellules mémoire non fonctionnelles n'étant pas sélectionnées tant que la section de décodage spéciale n'est pas activée.

Selon un mode de réalisation, la mémoire comprend un registre pour la mémorisation d'un bit d'autorisation de brouillage dont la valeur détermine la valeur du signal d'autorisation de brouillage.

Selon un mode de réalisation, la mémoire comprend des moyens d'effacement et de programmation des cellules mémoire non fonctionnelles, permettant de placer sélectivement des cellules mémoire non fonctionnelles dans un état déterminé, effacé ou programmé, tel que les cellules mémoire non fonctionnelles sont passantes lorsqu'elles sont sélectionnées.

Selon un mode de réalisation, le décodeur d'adresse de ligne de mot reçoit une adresse de ligne de mot étendue comprenant au moins un bit d'adresse supplémentaire relativement au nombre de bit d'adresse que nécessite l'adressage des lignes de mot fonctionnelles, et sélectionne individuellement la ligne de mot non fonctionnelle en effacement ou en programmation lorsqu'une adresse étendue de valeur prédéterminée lui est appliquée.

Selon un mode de réalisation, la mémoire comprend une unité centrale pour décoder et exécuter une instruction de programmation ou d'effacement de cellules mémoire non fonctionnelles.

Selon un mode de réalisation, la ligne de mot non fonctionnelle est mélangée aux lignes de mot fonctionnelles, et se trouve à un emplacement pouvant correspondre à celui d'une ligne de mot fonctionnelle.

Selon un mode de réalisation, les cellules mémoire non fonctionnelles ont la même structure que les cellules mémoire fonctionnelles et ne peuvent être distinguées visuellement de celles-ci.

Selon un mode de réalisation, les cellules mémoire non fonctionnelles comportent des transistors factices présentant un court-circuit drain-source.

La présente invention concerne également un circuit intégré comprenant une mémoire selon l'invention.

Selon un mode de réalisation, le circuit intégré comprend des moyens pour activer la section de décodage spéciale du décodeur d'adresse de ligne de mot lorsqu'un évènement inattendu ou interdit se produit dans le circuit intégré, de manière que des données présentes dans le plan mémoire ne soient accessibles en lecture que sous une forme brouillée.

La présente invention concerne également une carte à puce comprenant un circuit intégré selon l'invention.

Ces objets, caractéristiques et avantages ainsi que d'autres de la présente invention seront exposés plus en détail dans la description suivante d'un exemple de mise en oeuvre du procédé de l'invention dans une mémoire EEPROM, ainsi qu'un exemple de mise en oeuvre dans une mémoire Flash, la présente description étant faite à titre non limitatif en relation avec les figures jointes parmi lesquelles :
- la figure 1 représente schématiquement l'architecture d'une mémoire EEPROM selon l'invention, et
- la figure 2 représente schématiquement l'architecture d'un plan mémoire Flash selon l'invention.

Dans ce qui suit, on désigne par "non fonctionnelles" des cellules mémoire qui n'ont pas pour but de stocker des données d'application (données de l'utilisateur) mais ont pour but de fausser la lecture de données dans le plan mémoire, et on désigne par "fonctionnelles" les cellules mémoire recevant des données d'application.

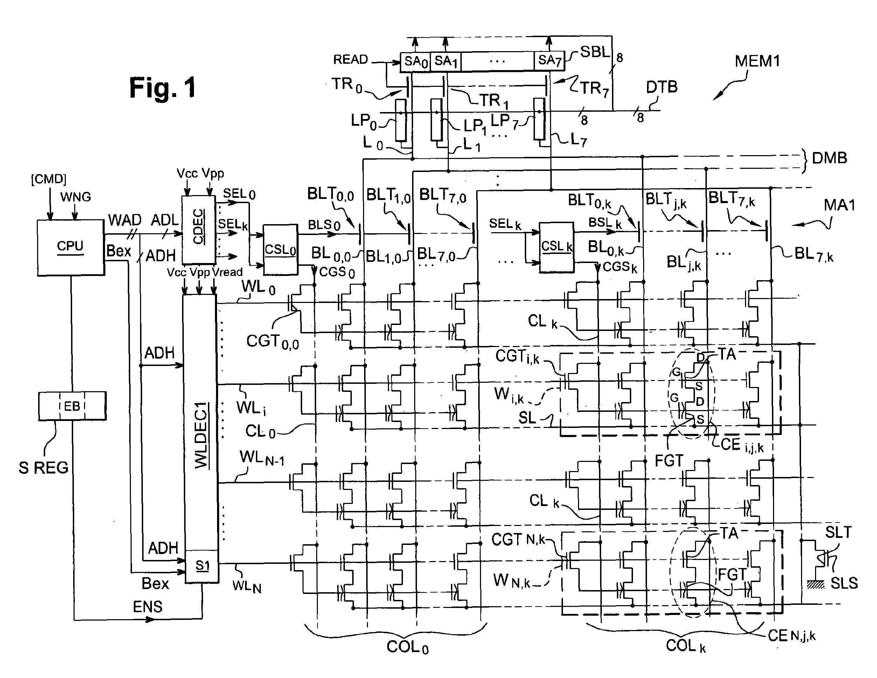

La figure 1 représente une mémoire non volatile MEM1 du type EEPROM (effaçable et programmable électriquement) dans laquelle le procédé de l'invention est mis en oeuvre. La mémoire comprend un plan mémoire MA1, un décodeur d'adresse de ligne de mot WLDEC1 et un décodeur de colonne CDEC. Le plan mémoire MA1 comprend des cellules mémoire fonctionnelles CE_{i,j,k} connectées à des lignes de mot fonctionnelles WLi et à des lignes de bit BL_{j,k}. Le plan mémoire est ici du type programmable par mots de 8 bits (octets), de sorte que les lignes de bit sont regroupées en colonnes COLₖ comprenant chacune 8 lignes de bit BL_{0,k}-BL_{7,k} (j étant un indice allant de 1 à 7 à l'intérieur d'une colonne de rang k).

Le plan mémoire comporte N lignes de mot fonctionnelles WL₀-WL_{N-1} (i allant de 0 à N-1), et un nombre de colonnes COLₖ correspondant au nombre d'octets que l'on souhaite pouvoir enregistrer dans une même rangée de cellules (formée par des cellules connectées à une même ligne de mot).

Le plan mémoire comporte également une ligne de mot supplémentaire WL_{N}, ou ligne de mot non fonctionnelle, qui sera décrite plus loin. On décrira tout d'abord les aspects de la mémoire qui sont en soi classiques.

Chaque cellule mémoire CE_{i,j,k} comprend un transistor à grille flottante FGT et un transistor d'accès TA. Le transistor d'accès TA a sa grille G connectée à une ligne de mot WLi, son drain D connecté à une ligne de bit BL_{j,k}, et sa source S connectée au drain D du transistor FGT. La grille de contrôle G du transistor FGT est reliée à une ligne de sélection de colonne CLₖ par l'intermédiaire d'un transistor de contrôle de grille CGT_{i,k} dont la grille est connectée à la ligne de mot WLi. La source du transistor FGT est connectée à une ligne de source SL commune à toutes les cellules mémoire, qui peut être portée à un potentiel flottant ou être connectée à la masse au moyen d'un transistor SLT piloté par un signal SLS.

Chaque groupe de huit cellules CE_{i,j,k} forme un mot W_{i,k} pouvant être sélectionné au moyen de la ligne de sélection de colonne CLₖ et de la ligne de mot WLi correspondantes. Les grilles de contrôle des transistors FGT des huit cellules mémoire du mot sont reliées à un transistor de contrôle de grille CGT_{i,k} commun, et reçoivent ainsi le même signal de contrôle de grille CGSₖ.

Les lignes de mot WLi sont pilotées par le décodeur d'adresse de ligne de mot WLDEC1. Les lignes de sélection de colonne CLₖ sont contrôlées par des verrous de sélection de colonne CSLₖ, eux-mêmes pilotés par un signal de sélection de colonne SELₖ fourni par le décodeur de colonne CDEC. Chaque verrou CSLₖ fournit deux signaux, respectivement le signal de contrôle de grille CGSₖ, qui est appliqué à la ligne de sélection de colonne CLₖ correspondante, et un signal de sélection de lignes de bit BLSₖ appliqué à des transistors de sélection de lignes de bit décrits plus loin.

Le décodeur d'adresse de ligne de mot WLDEC1 reçoit une adresse de poids fort ADH, ou adresse de ligne de mot, et le décodeur de colonne CDEC reçoit une adresse de poids faible ADL, ou adresse de colonne. Ces deux adresses forment ensemble l'adresse WAD d'un mot dans la mémoire.

La mémoire MEM1 comprend également huit verrous de programmation LP₀-LP₇ et huit amplificateurs de lecture SA₀-SA₇ ("sense amplifiers"). Les sorties des amplificateurs SA₀-SA₇ et les entrées des verrous LP₀-LP₇ sont connectées à un bus de données DTB. Ce bus véhicule des données fournies par les amplificateurs de lecture pendant des phases de lecture, ou des données à charger dans les verrous de programmation avant les phases de programmation. Les sorties des verrous de programmation SA₀ à SA₇ sont connectées à des lignes L₀ à L₇ de rang correspondant. Les entrées des amplificateurs de lecture sont reliées aux lignes L₀-L₇ de rang correspondant par l'intermédiaire de transistors de lecture TR₀-TR₇ pilotés par un signal READ.

Les lignes L₀-L₇ sont reliées aux lignes de bit BL_{0,k}-BL_{7,k} de chaque colonne COLₖ par l'intermédiaire d'un bus de démultiplexage DMB. Ce bus DMB est agencé de manière à créer des chemins de connexion entre, d'une part, la sortie de chaque verrou de programmation LPⱼ (LP₀-LP₇) et l'entrée de chaque amplificateur de lecture SAⱼ (SA₀-SA₇) et, d'autre part, les lignes de bit BL_{j,k} de même rang j présentes dans chacune des colonnes. Chaque ligne de bit BL_{0,k}-BL_{7,k} de chaque colonne COLₖ est reliée au bus de multiplexage par l'intermédiaire d'un transistor de sélection de ligne de bit BLT_{0,k}-BLT_{7,k} de rang correspondant. Les transistors BLT_{0,k}-BLT_{7,k} appartenant à une même colonne sont pilotés par le signal de sélection de lignes de bit BLSₖ fourni par le verrou CSLₖ de sélection de la colonne considérée.

Dans une telle mémoire, une opération d'effacement ou de programmation d'une cellule mémoire consiste en une injection ou une extraction de charges électriques par effet tunnel (effet Fowler Nordique) dans la grille flottante du transistor FGT. L'opération d'effacement est réalisée en appliquant une tension d'effacement Vpp de l'ordre de 10 à 20 V sur la grille G du transistor FGT pendant que la ligne de source SLi est portée à la masse, la borne de drain étant flottante. L'opération de programmation est réalisée en appliquant une tension de programmation Vpp sur le drain D du transistor FGT, par l'intermédiaire du transistor d'accès TA, pendant que sa grille est portée à la masse, la borne de source étant flottante.

Pendant l'effacement des cellules mémoire d'un mot W_{i,k}, le verrou de sélection de colonne CSLₖ correspondant est activé par le signal de sélection de colonne SELₖ. Le verrou CSLₖ porte à la tension Vpp le signal de contrôle de grille CGSₖ et met à 0 (masse) le signal de sélection de lignes de bit BLSₖ. Le décodeur WLDEC1 applique à la ligne de mot sélectionnée WLi la tension Vpp. La ligne de source SL est connectée à la masse. Les transistors BLT_{0,k}-BLT_{7,k} sont bloqués et les lignes de bit sont déconnectées des verrous de programmation et des amplificateurs de lecture. Le transistor de contrôle de grille CGT_{i,k} est passant et les grilles des transistors FGT reçoivent la tension Vpp. Des charges électriques sont extraites des grilles flottantes des transistors FGT.

Pendant la programmation des cellules mémoire du mot W_{i,k}, le verrou CSLₖ met à 0 le signal de contrôle de grille CGSₖ et porte à la tension Vpp le signal de sélection de lignes de bit BLSₖ. Le décodeur WLDEC1 applique à la ligne de mot sélectionnée WLi la tension Vpp. La ligne de source SL est connectée à la masse. Les transistors BLT_{0,k}-BLT_{7,k} sont passants et connectent les sorties des verrous de programmation LP₀-LP₇ aux lignes de bit de la colonne. Chaque verrou LP₀-LP₇ fournit la tension Vpp ou une tension nulle selon la valeur du bit de donnée qui a été préalablement chargée dans le verrou. Le transistor CGT_{i,k} applique le signal de contrôle de grille CGSₖ aux transistors FGT. Des charges électriques sont injectées dans les grilles flottantes des transistors FGT, lorsque les verrous de programmation correspondants fournissent la tension Vpp.

Pendant la lecture du mot W_{i,k}, le verrou CSLₖ porte le signal CGSₖ à une tension de lecture Vread, tandis que le signal de sélection de lignes de bit BLSₖ est porté à une tension déterminée, par exemple la tension d'alimentation Vcc de la mémoire. Le décodeur WLDEC1 applique à la ligne de mot sélectionnée WLi la tension Vcc, le signal READ est mis à 1 et les lignes de source SL sont connectées à la masse.

Les transistors TR₀-TR₇ sont passants ainsi que les transistors BLT_{0,k}-BLT_{7,k} de sorte que les amplificateurs de lecture SA₀-SA₇ sont connectés aux lignes de bit BL_{j,k} de la colonne sélectionnée. Le transistor de contrôle de grille CGT_{i,k} de la colonne est passant et la tension de lecture Vread est amenée jusqu'aux grilles des transistors FGT. Les transistors d'accès TA sont également passants, de sorte que les drains des transistors FGT sont connectés aux entrées des amplificateurs de lecture.

Un transistor FGT programmé présente une tension de seuil négative VT1 et un transistor FGT effacé présente une tension de seuil positive VT2. La tension de lecture Vread est choisie supérieure à VT1 et inférieure à VT2. Ainsi, lorsque la tension de lecture Vread est appliquée sur la grille d'un transistor FGT, le transistor reste bloqué s'il est dans l'état effacé, ce qui correspond par exemple à la fourniture d'un "1" en sortie de l'amplificateur de lecture correspondant. Inversement le transistor FGT est passant s'il est dans l'état programmé, ce qui correspond par exemple à la fourniture d'un "0" en sortie de l'amplificateur de lecture (les amplificateurs de lecture étant inverseurs ou non-inverseurs selon la convention de lecture choisie).

Le plan mémoire qui vient d'être décrit présente une architecture classique en ce qui concerne les N premières lignes de mot WL₀-WL_{N-1}, et est du type programmable par mot et effaçable par mot. Une telle architecture représente le cas le plus difficile pour la mise en oeuvre d'un processus de destruction de données dans une situation d'urgence, car les mots doivent être effacés les uns après les autres et la durée du processus de destruction est longue au regard du temps conféré pour réagir à la demande de destruction de données.

Comme indiqué plus haut, la mémoire MEM1 se distingue tout d'abord d'une mémoire classique par le fait qu'au moins une rangée de cellules mémoire, ici la rangée correspondant à la dernière ligne de mot WL_{N}, est formée de cellules mémoire non fonctionnelles, qui ne sont pas destinées à mémoriser des données d'application. Ces cellules mémoire C_{N,j,k} (i=N) présentent ici une structure strictement identique à celle des cellules mémoire fonctionnelles, y compris en ce qui concerne leurs connexions à la ligne de mot WL_{N} et aux lignes de bit BL_{j,k}.

Le décodeur d'adresse de ligne de mot WLDEC1 comporte une section de décodage spéciale S1 qui assure le contrôle de la ligne de mot non fonctionnelle WL_{N}, et présente un état actif et un état inactif.

Lorsque la section de décodage S1 est inactive, la mémoire fonctionne en lecture comme une mémoire classique et la ligne de mot WL_{N} n'est jamais sélectionnée en lecture.

Lorsque la section de décodage S1 est active, elle applique la tension de sélection, par exemple la tension Vcc, à la ligne de mot WL_{N} Cette application est faite de façon permanente, ou au moins lorsqu'une opération de lecture des cellules fonctionnelles intervient. Comme indiqué plus haut, une opération de lecture intervient quand le décodeur WLDEC1 applique la tension de sélection Vcc à une ligne de mot fonctionnelle WLₖ désignée par l'adresse ADH, et quand une ligne de sélection de colonne CLₖ reçoit la tension de lecture Vread.

Dans ce cas, comme les mots W_{N,k} formés par les cellules mémoire non fonctionnelles sont également reliés aux lignes de sélection de colonne CLₖ, deux opérations de lecture se produisent simultanément dans la même colonne :
1) les transistors FGT des cellules mémoire fonctionnelles du mot W_{i,k} désignée par l'adresse ADH, se retrouvent connectés aux lignes de bit de la colonne concernée et reçoivent la tension de lecture Vread sur leurs grilles, leurs sources étant à la masse,
2) les transistors FGT des cellules mémoire non fonctionnelles d'un mot W_{N,k} de la même colonne COLₖ, se retrouvent également connectés aux lignes de bit de la colonne sélectionnée et reçoivent également la tension Vread sur leurs grilles, leurs sources étant également à la masse.

Ainsi, lorsque la section de décodage S1 est active, l'entrée de chaque amplificateur de lecture SA₀-SA₇ se trouve connectée aux drains de deux transistors à grille flottante FGT, à savoir le transistor à grille flottante de la cellule mémoire fonctionnelle devant être lue, et le transistor à grille flottante de la cellule non fonctionnelle. Si la cellule non fonctionnelle est dans l'état programmé, le résultat de la lecture est faussé car le transistor à grille flottante de cette cellule mémoire est passant et un courant apparaît dans la ligne de bit (la tension drain-source étant fournie par l'amplificateur de lecture). L'amplificateur de lecture fournit alors un bit égal à 0 quel que soit l'état de conductivité du transistor de la cellule mémoire fonctionnelle.

Le tableau 1 ci-après résume ce qui vient d'être décrit et donne le résultat de la lecture d'une cellule mémoire fonctionnelle lorsque la section de décodage S1 est inactive ("lecture normale") et lorsque la section de décodage S1 est active ("lecture faussée"). Il apparaît clairement qu'une cellule mémoire non fonctionnelle dans l'état programmé impose la valeur 0 comme résultat de lecture (Cf. deux dernières lignes du tableau 1). Comme indiqué plus haut, l'état passant d'une cellule mémoire correspond ici à l'état programmé.

**Tableau 1**

| Opération | Cellule mémoire fonctionnelle | Cellule mémoire non fonctionnelle | Résultat de la lecture |
|---|---|---|---|
| Lecture normale (section S1 inactive) | Passant | - | 0 |
| | Bloqué | - | 1 |
| Lecture faussée (section S1 active) | Passant | Bloqué | 0 |
| | Bloqué | Bloqué | 1 |
| | Passant | Passant | 0 |
| | Bloqué | Passant | 0 |

En pratique, le procédé selon l'invention peut être mis en oeuvre de deux manières :
1) toutes les cellules mémoire non fonctionnelles sont mises dans l'état programmé,
2) une partie seulement des cellules mémoire non fonctionnelles est mise dans l'état programmé.

Dans le premier cas, la lecture d'un mot quelconque du plan mémoire conduit à l'obtention du mot "00000000" en sortie des amplificateurs de lecture, ce qui est équivalent à une destruction totale des données présentes dans le plan mémoire. Cette "destruction" virtuelle selon l'invention est obtenue de façon quasi-immédiate par l'activation de la section de décodage S1.

Dans le second cas, la lecture de cellules mémoire non fonctionnelles conduit à l'obtention de mots erronés comportant des bits valables et des bits erronés. Pour fixer les idées, considérons la superposition en lecture des mots suivants :
0100 1111 (cellules mémoire fonctionnelles)
0011 0110 (cellules mémoire non fonctionnelles)
Le "0" l'emportant sur le "1", le résultat de la lecture est le suivant :
0000 0110
Le mot lu constitue ainsi une information erronée inexploitable pour un éventuel fraudeur.

Le procédé selon l'invention permet ainsi de fausser une lecture de données d'une manière plus difficilement détectable que lorsque toutes les données lues sont à 0. Un tel brouillage de données peut faire l'objet de diverses applications qui vont au-delà du problème technique initialement exposé. Un exemple d'utilisation consiste à placer une mémoire dans un mode de sécurité pendant des périodes où elle n'est pas supposée faire l'objet d'un accès en lecture. Le brouillage des données peut également être activé à toutes fins utiles quand un circuit intégré se trouve dans un mode de fonctionnement suspect, par exemple lorsque des organes de contrôle du circuit intégré détectent que des opérations non prévues sont effectuées par le circuit intégré.

L'activation de la section de décodage S1 peut être obtenue de diverses manières, et de façon réversible ou irréversible. Sur la figure 1, La mémoire comprend ici un CPU (unité de contrôle et de traitement) qui reçoit, décode et exécute des commandes CMD d'accès à la mémoire, notamment des commandes d'effacement, de programmation et de lecture. L'activation de la section de décodage S1 est prévue réversible et est obtenue en lui appliquant un signal d'autorisation de brouillage ENS. Le signal d'autorisation ENS est l'image d'un bit d'autorisation EB mémorisé par un registre d'état SREG, dont la gestion est assurée par le CPU. Plus particulièrement, le CPU reçoit un signal d'alerte WNG et est agencé pour mettre le bit EB à une valeur active lorsque le signal d'alerte WNG présente lui-même une valeur active, par exemple 1. Un tel signal d'alerte, en soi classique, est utilisé dans l'art antérieur pour déclencher l'effacement du plan mémoire. Il sert ici à activer le brouillage de la lecture des données.

Selon un aspect optionnel de l'invention, la section de décodage S1 peut également être utilisée pour contrôler en effacement et en programmation la ligne de mot non fonctionnelle WL_{N}, en appliquant les tensions décrites plus haut (Vpp en effacement et Vcc en programmation). Dans ce cas, le CPU est agencé pour décoder et exécuter, en sus des commandes classiques susmentionnées, des commandes spéciales visant à effacer ou à programmer des cellules mémoire non fonctionnelles.

A cet effet, l'adresse de ligne de mot ADH est appliquée à la section S1. L'adresse ADH comprend n bits d'adresse permettant de désigner l'une des N lignes de mot fonctionnelles WL₀-WL_{N-1}, n étant tel que N = 2ⁿ. La section de décodage S1 reçoit en sus de l'adresse ADH un bit d'extension d'adresse Bex fournit par le CPU. Le bit d'extension d'adresse est concaténé avec l'adresse ADH pour former une adresse étendue de n+1 bits. L'adresse étendue permet de former 2N adresses différentes parmi lesquelles les N premières adresses (Bex=0) sont réservées à l'adressage des N lignes de mot WL₀-WL_{N-1}. Parmi les N adresses restant disponibles, une adresse et une seule, tenue secrète, est dédiée à la sélection de la ligne de mot WL_{N} par la section S1, pour les opérations d'effacement ou de programmation. Dans une variante, le bit d'extension Bex peut être utilisé comme signal de sélection de la section S1, sans tenir compte de l'adresse ADH. Toutefois, le risque de fraude par violation du bit Bex est dans ce cas plus élevé.

L'effacement ou la programmation des cellules mémoire non fonctionnelles peut être faite une fois pour toutes lors de la mise en service de la mémoire, par exemple lors de l'exécution d'un programme de test qui applique au CPU les commandes spéciales susmentionnées.

D'autres moyens de sélection en programmation ou d'effacement peuvent être prévus, par exemple des signaux spécifiques de programmation et d'effacement.

La présente invention est susceptible de diverses variantes de réalisation. Les transistors à grille flottante FGT peuvent notamment être remplacés par des éléments antifusibles (sandwich polysilicium-oxyde-polysilicium) qui deviennent conducteurs après avoir reçu une tension de claquage. Cette tension de claquage peut être la tension de programmation Vpp.

Il est toutefois souhaitable, lorsque la présente invention est mise en oeuvre dans un but sécuritaire, que les cellules mémoire non fonctionnelles ne puissent pas se distinguer des cellules mémoire fonctionnelles au plan visuel. L'utilisation de transistors ou d'éléments ressemblants à des transistors est dans ce cas souhaitable, et de plus la ligne de mot non fonctionnelle, au lieu d'être agencée en tant que dernière ligne de mot du plan mémoire, peut être dissimulée au sein du plan mémoire, au milieu des lignes de mot fonctionnelles.

Les cellules mémoire non fonctionnelles peuvent par ailleurs ne pas être programmables ni effaçables, et être "préprogrammées" par construction. Notamment, des transistors à grille flottante FGT factices présentant un court-circuit drain-source peuvent être prévus. De tels transistors factices étant continuellement passants, ils sont équivalents à des transistors non factices se trouvant dans l'état programmé et recevant sur leur grille une tension de lecture.

Dans ce cas, la section de décodage peut ne comprendre qu'un simple élément antifusible qui, une fois claqué, assure l'application permanente de la tension Vcc à la ligne de mot non fonctionnelle WL_{N}, de sorte que les transistors d'accès des cellules mémoire non fonctionnelles connectent en permanence les transistors factices aux lignes de bit.

Enfin, la présente invention est également applicable à d'autres types de mémoire, notamment aux mémoires Flash.

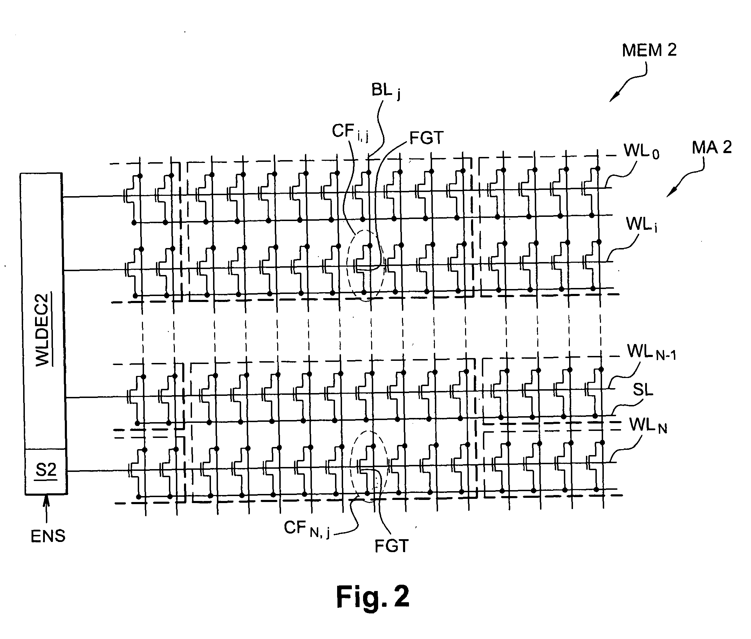

La figure 2 représente très schématiquement un exemple de mémoire MEM2 de type Flash comprenant un plan mémoire MA2 selon l'invention. Ce plan mémoire comprend comme le précédent un décodeur d'adresse de ligne de mot WLDEC2, des lignes de bit BLⱼ, N lignes de mot fonctionnelles WL₀-WL_{N-1} auxquelles sont reliées des cellules mémoire fonctionnelles CF_{i,j} et une ligne de mot non fonctionnelle WL_{N} selon l'invention à laquelle sont reliées des cellules mémoire non fonctionnelles CF_{N,j}. Les cellules mémoire CF_{i,j}, CF_{N,j} se distinguent des précédentes en ce qu'elles ne comprennent chacune qu'un transistor à grille flottante FGT dont la grille est directement connectée à la ligne de mot WLᵢ correspondante, dont le drain est directement connecté à la ligne de bit BLi correspondante, et dont la source est connectée à une ligne de source. Le décodeur WLDEC2 comprend comme le précédent une section de décodage spéciale S2 qui contrôle la ligne non fonctionnelle WL_{N}.

Dans une telle mémoire Flash, les lignes de bit ne sont pas regroupées en colonnes comme dans la mémoire EEPROM, de sorte que l'indice de colonne "k" ne figure pas dans la notation employée. La sélection des groupes de lignes de bit contenant les bits d'un mot binaire est assurée par des transistors de sélection de lignes de bit, non représentés sur la figure. Les transistors FGT sont programmés par injection de porteurs chauds ("hot carriers injection") et effacés par effet tunnel. Un transistor FGT programmé présente ici une tension de seuil positive VT1 et un transistor FGT effacé présente une tension de seuil positive VT2 supérieure à VT1. La tension de lecture Vread appliquée à une ligne de mot WLᵢ sélectionnée est choisie supérieure à VT1 et inférieure à VT2. Ainsi, la section de décodage spéciale S2, tant qu'elle n'est pas activée, maintient une tension nulle sur la ligne de mot non fonctionnelle WL_{N}, et applique la tension de lecture Vread lorsqu'elle est activée, de sorte que les cellules mémoire non fonctionnelles dans l'état programmé faussent la lecture des cellules mémoire fonctionnelles. Dans une variante de réalisation, la section spéciale de décodage, lorsqu'elle est activée, applique à la ligne de mot non fonctionnelle WL_{N} une tension supérieure à la tension de seuil VT2 d'un transistor FGT effacé, de sorte que tous les transistors FGT formant les cellules mémoire non fonctionnelles sont alors passants, qu'ils soient dans l'état programmé ou effacé.

Il apparaîtra clairement à l'homme de l'art que la présente invention est susceptible de diverses autres variantes, et de diverses autres applications.

## Revendications

1. Procédé pour brouiller la lecture de données dans des cellules mémoire fonctionnelles (CE_{i,j,k}, CF_{i,j}) d'un plan mémoire non volatile (MA1, MA2), dans lequel les cellules mémoire fonctionnelles sont reliées à des lignes de mot fonctionnelles (WL₀-WL_{N-1}) et à des lignes de bit (BL_{j,k}, BLⱼ), les lignes de bit étant reliées à des amplificateurs de lecture (SA0-SA7), et dans lequel la valeur d'une donnée lue par un amplificateur de lecture dans une cellule mémoire est fonction de l'état passant ou bloqué de la cellule mémoire, qui est lui-même fonction de l'état programmé ou effacé de la cellule mémoire,
procédé **caractérisé en ce qu'**il comprend les étapes consistant à:
- prévoir des cellules mémoire non fonctionnelles (CE_{N,j,k}, CF_{N,j}) reliées aux lignes de bit (BL_{j,k}, BLⱼ) du plan mémoire et à au moins une ligne de mot non fonctionnelle (WL_{N}) permettant de sélectionner les cellules mémoire non fonctionnelles, et
- quand des cellules mémoire fonctionnelles (CE_{i,j,k}, CF_{i,j}) sont sélectionnées en lecture, sélectionner simultanément des cellules mémoire non fonctionnelles (CE_{N,j,k}, CF_{N,j}), de telle sorte que les cellules mémoire non fonctionnelles se trouvant dans l'état passant interfèrent sur la lecture des cellules mémoire fonctionnelles se trouvant dans l'état bloqué, et provoquent la fourniture de valeurs logiques faussées en sortie des amplificateurs de lecture.

2. Procédé selon la revendication 1, comprenant la prévision d'un décodeur d'adresse de ligne de mot (WLDEC1, WLDEC2) comprenant une section de décodage spéciale (S1, S2) reliée à la ligne de mot non fonctionnelle (WL_{N}), pour appliquer un signal de sélection (Vcc, Vread) à la ligne de mot non fonctionnelle quand une ligne de mot fonctionnelle est sélectionnée en lecture par le décodeur d'adresse de ligne de mot.

3. Procédé selon la revendication 2, comprenant la prévision d'une section de décodage spéciale qui est activée par un signal d'autorisation de brouillage (ENS), les cellules mémoire non fonctionnelles n'étant pas sélectionnées tant que la section de décodage spéciale n'est pas activée.

4. Procédé selon la revendication 3, comprenant la prévision d'un registre (SREG) pour la mémorisation d'un bit d'autorisation de brouillage (EB) dont la valeur détermine la valeur du signal d'autorisation de brouillage.

5. Procédé selon l'une des revendications 1 à 4, comprenant une étape consistant à porter toutes les cellules mémoire non fonctionnelles (CE_{N,j,k}, CF_{N,j}) dans un état déterminé, programmé ou effacé, de manière que toutes les cellules mémoire non fonctionnelles soient dans l'état passant lorsqu'elles sont sélectionnées, afin de fausser la lecture de toutes les cellules mémoire fonctionnelles.

6. Procédé selon l'une des revendications 1 à 5, comprenant une étape consistant à porter une partie seulement des cellules mémoire non fonctionnelles (CE_{N,j,k}, CF_{N,j}) dans un état déterminé, programmé ou effacé, de manière que les cellules mémoire non fonctionnelles soient dans l'état passant lorsqu'elles sont sélectionnées, afin de fausser la lecture d'une partie seulement des cellules mémoire fonctionnelles.

7. Procédé selon l'une des revendications 1 à 6, dans lequel la ligne de mot non fonctionnelle (WL_{N}) est mélangée aux lignes de mot fonctionnelles, et se trouve à un emplacement pouvant correspondre à celui d'une ligne de mot fonctionnelle.

8. Procédé selon l'une des revendications 1 à 7, comprenant la prévision de cellules mémoire non fonctionnelles ayant la même structure que les cellules mémoire fonctionnelles et ne pouvant être distinguées visuellement de celles-ci.

9. Procédé selon l'une des revendications 1 à 8, comprenant la prévision de cellules mémoire non fonctionnelles comportant des transistors factices présentant un court-circuit drain-source.

10. Mémoire non volatile (MEM1, MEM2) comprenant un plan mémoire (MA1, MA2) comportant des cellules mémoire fonctionnelles (CE_{i,j,k}, CF_{i,j}) reliées à des lignes de mot fonctionnelles (WL₀-WL_{N-1}) et à des lignes de bit (BL_{j,k}, BLⱼ), les lignes de bit étant reliées à des amplificateurs de lecture (SA0-SA7), les lignes de mot étant reliées à un décodeur d'adresse de ligne de mot (WLDEC1, WLDEC2), la valeur d'une donnée lue par un amplificateur de lecture dans une cellule mémoire étant fonction de l'état passant ou bloqué de la cellule mémoire, qui est lui-même fonction de l'état programmé ou effacé de la cellule mémoire, mémoire **caractérisée en ce que** :
- le plan mémoire comprend des cellules mémoire non fonctionnelles (CE_{N,j,k}, CF_{N,j}) reliées aux lignes de bit (BL_{j,k}, BLⱼ) du plan mémoire et à au moins une ligne de mot non fonctionnelle (WL_{N}), et
- le décodeur d'adresse de ligne de mot (WLDEC1, WLDEC2) comprend une section de décodage spéciale (S1, S2) reliée à la ligne de mot non fonctionnelle, pour sélectionner la ligne de mot non fonctionnelle quand une ligne de mot fonctionnelle est sélectionnée en lecture, de telle sorte que des cellules mémoire non fonctionnelles (CE_{N,j,k}, CF_{N,j}) sont sélectionnées simultanément aux cellules mémoire fonctionnelles (CE_{i,j,k}, CF_{i,j}) et brouillent la lecture des cellules mémoire fonctionnelles.

11. Mémoire selon la revendication 10, dans laquelle la section de décodage spéciale (S1, S2) du décodeur d'adresse de ligne de mot est activée par un signal d'autorisation de brouillage (ENS), les cellules mémoire non fonctionnelles n'étant pas sélectionnées tant que la section de décodage spéciale n'est pas activée.

12. Mémoire selon l'une des revendications 10 et 11, comprenant un registre (SREG) pour la mémorisation d'un bit d'autorisation de brouillage (EB) dont la valeur détermine la valeur du signal d'autorisation de brouillage.

13. Mémoire selon l'une des revendications 10 à 12, comprenant des moyens d'effacement et de programmation des cellules mémoire non fonctionnelles (CE_{N,j,k}, CF_{N,j}), permettant de placer sélectivement des cellules mémoire non fonctionnelles dans un état déterminé, effacé ou programmé, tel que les cellules mémoire non fonctionnelles sont passantes lorsqu'elles sont sélectionnées.

14. Mémoire selon l'une des revendications 10 à 13, dans laquelle le décodeur d'adresse de ligne de mot reçoit une adresse de ligne de mot étendue comprenant au moins un bit d'adresse (Bex) supplémentaire relativement au nombre de bit d'adresse que nécessite l'adressage (ADH) des lignes de mot fonctionnelles, et sélectionne individuellement la ligne de mot non fonctionnelle en effacement ou en programmation lorsqu'une adresse étendue de valeur prédéterminée lui est appliquée.

15. Mémoire selon l'une des revendications 10 à 14, comprenant une unité centrale (CPU) pour décoder et exécuter une instruction de programmation ou d'effacement de cellules mémoire non fonctionnelles.

16. Mémoire selon l'une des revendications 10 à 15, dans laquelle la ligne de mot non fonctionnelle (WL_{N}) est mélangée aux lignes de mot fonctionnelles, et se trouve à un emplacement pouvant correspondre à celui d'une ligne de mot fonctionnelle.

17. Mémoire selon l'une des revendications 10 à 16, dans laquelle les cellules mémoire non fonctionnelles (CE_{N,j,k}, CF_{N,j}) ont la même structure que les cellules mémoire fonctionnelles (CE_{i,j,k}, CF_{i,j}) et ne peuvent être distinguées visuellement de celles-ci.

18. Mémoire selon l'une des revendications 10 à 17, dans laquelle les cellules mémoire non fonctionnelles comportent des transistors factices présentant un court-circuit drain-source.

19. Circuit intégré comprenant une mémoire selon l'une des revendications 10 à 18.

20. Circuit intégré selon la revendication 19, comprenant des moyens (WNG, CUP) pour activer la section de décodage spéciale (S1, S2) du décodeur d'adresse de ligne de mot lorsqu'un évènement inattendu ou interdit se produit dans le circuit intégré, de manière que des données présentes dans le plan mémoire ne soient accessibles en lecture que sous une forme brouillée.

21. Carte à puce, **caractérisée en ce qu'**elle comprend un circuit intégré selon l'une des revendications 19 et 20.
